# EUROPEAN PATENT SPECIFICATION

(11) **EP 4 086 910 B1**
(45) Date of publication and mention of the grant of the patent: **13.08.2025**
(21) Application number: 21172198.0
(22) Date of filing: 05.05.2021
(51) Int. Cl.: G06N 3/065, G11C 11/54, G11C 7/10, G11C 7/16, G11C 27/02, G06F 7/544, G11C 11/419, G11C 11/412

(54) **MULTIPLY-ACCUMULATE (MAC) UNIT FOR IN-MEMORY COMPUTING**
MULTIPLIKATIONS-ADDITIONS-EINHEIT FÜR SPEICHERINTERNE BERECHNUNG
UNITÉ DE MULTIPLICATION-ACCUMULATION (MAC) POUR CALCUL EN MÉMOIRE

(43) Date of publication of application: 09.11.2022
(73) Proprietor: Nokia Technologies Oy, 02610 Espoo (FI)
(72) Inventor: JIANG, Zhewei, Oakland Gardens, 11364 (US); CHOW, Hungkei, Livingston, 07039 (US)
(74) Representative: Sayer, Robert David

(56) References cited:
- US-A1- 2019 080 231
- XUE CHENG-XIN ET AL: "Embedded 1-Mb ReRAM-Based Computing-in- Memory Macro With Multibit Input and Weight for CNN-Based AI Edge Processors", IEEE JOURNAL OF SOLID-STATE CIRCUITS, IEEE, USA, vol. 55, no. 1, 1 January 2020 (2020-01-01), pages 203 - 215, XP011763109, ISSN: 0018-9200, [retrieved on 20191226], DOI: 10.1109/JSSC.2019.2951363
- JIANG ZHEWEI ET AL: "C3SRAM: An In-Memory-Computing SRAM Macro Based on Robust Capacitive Coupling Computing Mechanism", IEEE JOURNAL OF SOLID-STATE CIRCUITS, IEEE, USA, vol. 55, no. 7, 1 July 2020 (2020-07-01), pages 1888 - 1897, XP011795573, ISSN: 0018-9200, [retrieved on 20200626], DOI: 10.1109/JSSC.2020.2992886
- SHARMA VISHAL ET AL: "AND8T SRAM Macro with Improved Linearity for Multi-Bit In-Memory Computing", 2019 IEEE INTERNATIONAL SYMPOSIUM ON CIRCUITS AND SYSTEMS (ISCAS), IEEE, 22 May 2021 (2021-05-22), pages 1 - 5, XP033932783, ISSN: 2158-1525, ISBN: 978-1-7281-3320-1, [retrieved on 20210412], DOI: 10.1109/ISCAS51556.2021.9401665
- CHEN ZHIYU ET AL: "MC2-RAM: An In-8T-SRAM Computing Macro Featuring Multi-Bit Charge-Domain Computing and ADC-Reduction Weight Encoding", 2021 IEEE/ACM INTERNATIONAL SYMPOSIUM ON LOW POWER ELECTRONICS AND DESIGN (ISLPED), IEEE, 26 July 2021 (2021-07-26), pages 1 - 6, XP033952206, DOI: 10.1109/ISLPED52811.2021.9502505

## Description

### TECHNOLOGICAL FIELD

Example embodiments relate to In-Memory Computing (IMC) and, more specifically, an In-Memory Computing apparatus configured to perform a multiply-accumulate (MAC) operation.

### BACKGROUND

Integrated Circuits (ICs) are widespread in modern electronics and may be used to implement a wide range of processing and memory devices. In-memory computing technology is a developing area which aims to provide improvements in computational performance. Traditional systems tend to store data in memory that is separate from the processor which performs tasks such as arithmetic and logic functions. With the increase in data required for certain applications, such as with neural network processing, data movement between the processor and memory may present one of the more critical performance and energy bottlenecks. In-memory computing can improve processing performance through the use of memory technologies that are also able to perform certain computational tasks such as the arithmetic and/or logical functions.

XUE CHENG-XIN ET AL: "Embedded 1-Mb ReRAM-Based Computing-in-Memory Macro With Multibit Input and Weight for CNN-Based AI Edge Processors", 2020-01-01,discloses computing-in-memory based on embedded nonvolatile memory is a promising candidate for energy-efficient multiply-and-accumulate operations in artificial intelligence edge devices. This document discloses a method of serial input per row comprising:
- for each row of a bitcell array, receiving a weight value comprising M weight bits and receiving an input value comprising N input bits ;
- for each weight bit, storing the weight bit to a memory unit of a bitcell, wherein an entire weight value is distributed across M adjacent columns of bitcells; and
- computing an analog MAC result representing summed products of the input values and the weight values for each rows of the bitcell array, wherein computing the analog MAC result comprises:
   for each of N input cycles:
   - for each row, sending a corresponding input bit of the input value to the bitcell array;
   - for each row, multiplying the corresponding input bit of the input value by each weight bit stored to the bitcells.

JIANG ZHEWEI ET AL: "C3SRAM: An In-Memory-Computing SRAM Macro Based on Robust Capacitive Coupling Computing Mechanism", 2020-07-01, XP011795573, discloses an in-memory computing macro. The macro is an module with the circuits embedded in bitcells and peripherals to perform hardware acceleration for neural networks with binarized weights and activations.

US 2019/080231 A1, discloses systems and methods for reducing power in in-memory computing, matrix-vector computations, and neural networks

SHARMA VISHAL ET AL: "AND8T SRAM Macro with Improved Linearity for Multi-Bit In-Memory Computing", 2021-05-22, XP033932783, discloses a multi-bit precision in-memory computing architecture, based on the voltage scaling and charge sharing scheme, for artificial intelligence edge devices.

### BRIEF SUMMARY

The scope of protection sought for various embodiments of the invention is set out by the independent claims. The embodiments and features, if any, described in this specification that do not fall under the scope of the independent claims are to be interpreted as examples useful for understanding various embodiments of the invention.

Optional features or steps are set out by the dependent claims.

### BRIEF DESCRIPTION OF THE DRAWINGS

Example embodiments will now be described, with reference to the accompanying drawings, in which:
Fig. 1 is a block diagram of **a** compute-in-memory (CIM) module for performing a multiple-and-accumulate operation in accordance with embodiments;
Fig. 2 is a circuit diagram showing two adjacent bitcells in a single column of the bitcell array in accordance with embodiments;
Fig. 3 is a circuit diagram of **a** sample-and-hold circuit that **is** used to store the partial MAC result described in relation to Fig. 2;
Fig. 4 is a circuit diagram of **a** sample-and-hold circuit that is used to store MAC results in systems that use 2's complement arithmetic:
Fig. 5 is a circuit diagram of a sample-and-hold circuit that uses ping-pong buffering and is used to store MAC results in systems that use 2's complement arithmetic;
Fig. 6 is a circuit diagram of MAC result circuit used to accumulate the partial MAC results generated by the bitcell array in accordance with embodiments;
Fig. 7 is a circuit diagram of an example converter for converting the MAC results from analog to digital;
Fig. 8 is a block diagram of a compute-in-memory (CIM) device with multiple compute-in-memory modules in accordance with embodiments;
Fig. 9 is a block diagram of an example CIM system in accordance with embodiments; and
Fig. 10 is a process flow diagram summarizing a method for performing a multiply accumulate (MAC) operation using an in-memory computing device in accordance with embodiments.

### DETAILED DESCRIPTION

Example embodiments relate to integrated circuits (ICs) and integrated circuit fabrication techniques applicable to In-Memory Computing (IMC), also sometimes referred to as Computing-in-Memory (CIM) or Processing-in-Memory (PIM). More specifically, the present disclosure describes techniques for implementing a multiply accumulate (MAC) unit useful for In-Memory Computing.

The multiply-accumulate (MAC) operation is a building block of a variety of computational processes used in digital signal processing and machine learning (ML) algorithms. For example, the convolution function, also sometimes referred to as cross-correlation or sliding dot product, is produced by determining the integral of the product of the two functions for all possible values of shift. Convolution is used in a variety of computational operations, including signal processing, image processing, neural networks, and others.

In computer systems, convolution is a mathematical operation between two matrices often referred as an input window and a filter. For example, given a 10x10 matrix (the input window) and a 3x3 matrix (the filter), the process is to multiply the input window and the filter for each possible combination of positions as you superimpose the filter matrix over the input matrix. This can be accomplished by overlaying the filter at the first position, multiplying the overlapping values and adding them together to get the output, referred to herein as a dot product or partial sum. Next, the filter is shifted one or more column/row over and the same calculations are repeated. Once at the end of the row/column, the filter is shifted one or more row/column and the process repeated. This continues until the end of the input matrix is reached.

The efficiency of performing the multiple-accumulate operation often determines the overall performance of a hardware accelerator design. Some digital designs use an SRAM to store the matrix operands and digital logic to perform arithmetic operations. In such designs, the memory access presents a major bottleneck and often dominates power consumption.

By contrast, SRAM based in-memory computing circuits can use a dense array of SRAM-based bit cells, to perform a massive number of multiplication and summation operations simultaneously in mixed digital and analog domain. Performing computational operations at the memory cell removes the memory access bottleneck and greatly reduces the power consumption of accessing data. Accordingly, in-memory computing circuits can offer orders of magnitude higher computational throughput and energy efficiency as compared to digital logic designs. The computation performed by mixed signal circuits also presents a significant power and area saving.

However, many in-memory computing designs suffer from a limited precision. For example, many in-memory computing designs can only handle operands of 4 bits or less without losing accuracy. The present disclose describes various techniques that improve the in-memory computing design to achieve a higher precision and accuracy.

There are two broad categories of CIM computing mechanisms, current domain and charge domain techniques. In both techniques, the multiplication is performed within each bitcell while the accumulation is performed inter-bitcell (row, column, or both). In current domain CIM designs, the accumulation is achieved by applying multiple discharging paths to a constant supply or a single charge reservoir, where the total current or total charge displaced through timed current is used to represent the MAC result. In charge domain CIM designs, multiple charged/depleted capacitors are used to redistribute or couple the stored charges to achieve an analog voltage that represents the MAC result.

Multi-bit precision input can be represented in the current domain more easily than in charge domain, making it faster than multi-bit precision charge domain designs. However, current domain designs suffer more severely than charge domain designs from non-idealities such as IR drop and manufacturing variability, especially dopant variability. Due to the inherent noise in current, current domain techniques tend to be less accurate than charge domain techniques.

Charge domain techniques have the advantage of accuracy over the current domain techniques, since the accumulation mainly suffers geometric variability of the capacitors which is lower than current. However, multi-bit precision input cannot be represented by pulse width in charge domain designs. Instead, a multi-cycle operation is used, making it a slower approach.

Despite the higher accuracy, most charge domain CIM designs are used for low precision applications. The main issue is within bit-significance representation of both inputs and weights: the finer the bit-significance, the higher the energy used to perform CIM as the unit capacitance has physical limitations. Furthermore, the conventional circuitry used to integrate charges of differing bit-significance grows exponentially in area and energy cost. This patent presents novel techniques and methods to overcome those issues.

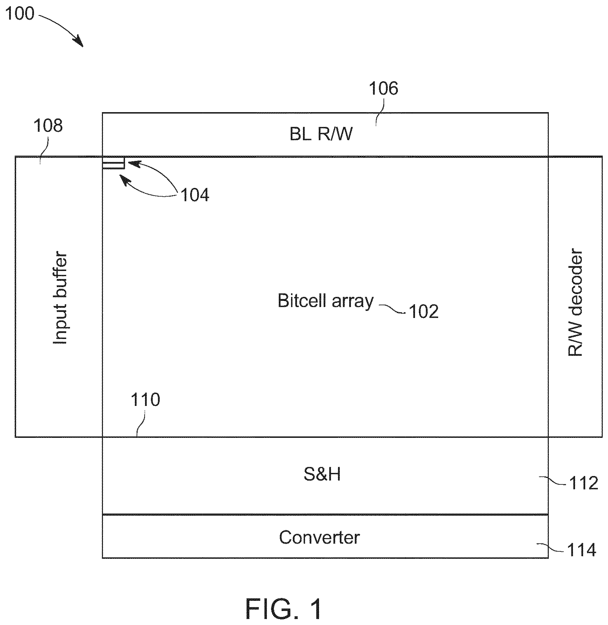

Embodiments of the present techniques provide a MAC accelerator apparatus with charge domain CIM modules. The top-level accelerator manages the data organization and mapping of various forms of machine learning layers to the CIM macros in order to perform MAC operations with multibit inputs, multibit weights, and multibit output precisions. The CIM modules compute in the charge domain, where the inputs are applied to the macro bit-serially whereas the weight bits are distributed across multiple columns of memory bitcells. The bitcells perform a binary multiplication in the digital domain, and the result determines the state of an output capacitor (charged or depleted). The output capacitors for a column of bitcells determine the charge stored to a holding capacitor for that column. The holding capacitors for adjacent bitcell columns form a capacitive voltage divider, resulting in an analog voltage that represents the MAC result. Sample-and-hold (S&H) circuits at the end of each column accumulate over multiple input cycles, representing the sum of each binary MAC result, accounting for the input bit significance. The capacitive voltage dividers form a C-2C ladder, which accumulate these charges over the columns to represent the final MAC results, which are summations of the partial results for each bit of the weights. The final analog voltage may then be digitized using a successive approximation register (SAR) Analog to Digital converter (ADC). Embodiments of the present techniques may be better understood with reference to Figs 1-10 and the accompanying text.

Fig. 1 is a block diagram of a compute-in-memory (CIM) module for performing a multiple-and-accumulate operation in accordance with embodiments. The CIM module 100 includes a bitcell array 102 that stores weight data and also performs bitwise multiplication of each weight and corresponding inputs from an input window. The state of each bitcell 104 determines whether it represents a value of zero or a value of one. Although only two bitcells 104 are shown, it will be appreciated that the bitcells array 102 can include any suitable number of bitcells, for example, several hundred bitcells. Bitcell states may be set or reset by a bit line Read/Write circuitry 106. Each bitcell 104 in the bitcell array 102 is configured to multiply its stored weight bit with a corresponding bit of input received from an input buffer 108. As used herein, the term input or input value is used to refer to the entire N-bit input, whereas the term input bit refers to a single bit of the input value. Similarly, the term weight or weight value is used to refer to the entire N-bit weight, whereas the term weight bit refers to a single bit of the weight value .

In the embodiment shown in Fig. 1, the bitcell array 102 is divided into regions 110, each of which can have a set of columns representing a different filter. Although only one region 110 is depicted, it will be appreciated that the bitcell array 102 may be divided into several regions of the same size as region 110. The number of columns in each region depends on the number of bits used to represent the filter weights. For purposes of the present description, each filter weight is represented by an 8-bit binary number occupying 8 columns of the bitcell array. Thus, each region 110 is eight columns of bitcells wide. However, the present techniques can be implemented for any suitable bit precision, including 4 bits or others. The weights in a particular region 110 represent a single filter which has been unrolled from the matrix form into one column. In some embodiments, the filter may be copied multiple times to the same column to account for multiple channels of input. For example, in a system with a 4-by-4 filter matrix and four input channels, each column with have 64 bitcells (16 weights per filter times 4 channels). In the bitcell array 102, weight bit significance is represented by the position of the bit in the 8-bit region.

Input values received from the input buffer 108 can have the same number of bits as the weights, but the input buffer is to serially send input bits of the multibit input to the bitcell array 102 one bit at a time starting with the least significant bit and ending with the most significant bit for a total of eight input cycles in the case of an 8-bit system. At each input cycle, the same input bit is fed into a full row of bitcells 104, but different rows can receive a different input bit depending on the input value received from the input window at that row position. The bitcells 104 process the input bits in parallel.

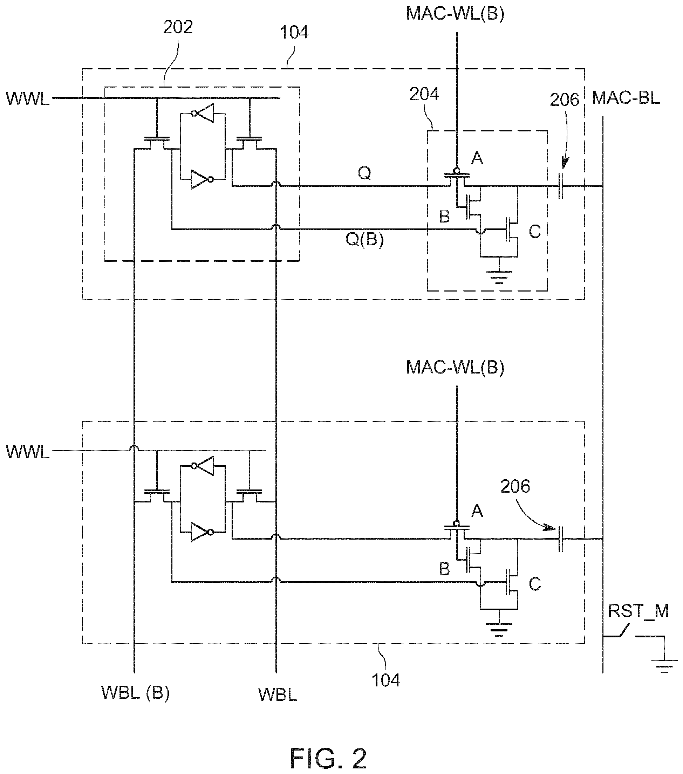

At each input cycle, each bitcell 104 multiplies the input bit with its own weight bit and outputs a zero charge if the result of the multiplication is zero or a non-zero charge if the result of the multiplication is one. All of the outputs in a single column are effectively summed in the analog domain through a capacitive coupling with a common capacitor plate. The total charge on the column is accumulated by holding capacitor, which is disposed at the end of the column and included in a sample-and-hold circuit 112. Each column of bitcells 104 is associated with a separate holding capacitor, and the separate holding capacitors form a C-2C ladder that represents the resulting output in analog form. After 8 input cycles, the final MAC result stored to the C-2C ladder represents the multiplication of the 8-bit filter weight by the 8-bit input value. The final result can then be converted to a digital value using a converter 114. Various components of the CIM module are described further in relation to Figs. 2-7.

Fig. 2 is a circuit diagram showing two adjacent bitcells in a single column of the bitcell array in accordance with embodiments. Each bitcell 104 includes a bit storage unit 202 for storing the state of the bitcell (1 or 0). The bit storage unit 202 stores a single bit of the multibit weight. The two bitcells 104 shown in Fig. 2 represent the same bit position of two different weights. Other bits of each weight are stored to adjacent bitcells in the same row (not shown). In the example of Fig. 2, the bit storage unit 202 is a Static Random-Access Memory (SRAM) circuit with two cross-coupled inverters positioned between two access transistors. Other types of bit storage units may also be used. The bit storage unit 202 has two stable states that are used to denote zero and one.

Access (read and write) to the bit storage unit 202 is enabled by the write word line (WWL) which controls the two access transistors. The access transistors control whether the bit storage unit 202 should be coupled to the write bit lines WBL and WBL(B). The write bit lines WBL and WBL(B) are bitwise complements that control the state of the bit storage unit 202, i.e., whether the bit storage unit 202 stores a one or a zero.

The output of the bit storage unit 202, Q and Q(B), is accessed at the outputs of the two cross-coupled inverters. The values on the two output lines will be bitwise complements that represent the value that was stored to the bit storage unit 202. For example, if the bit storage unit 202 stores a value of 1, then Q will equal 1 and Q(B) will equal zero. If the bit storage unit 202 stores a value of 0, then Q will equal 0 and Q(B) will equal 1.

The bitcell 104 also includes a multiplication unit 204 that performs a bitwise multiplication of the input bit and the weight bit. The multiplication unit 204 includes three transistors, labeled A, B, and C and is coupled to an output capacitor 206 that holds the charge representing the multiplication result. The multiplication unit 204 is controlled by the input bit on the MAC word line, MAC-WL(B), which represents the input received from the input buffer 108 (Fig. 1) after being inverted. If the input value is 1, the inverted input, MAC-WL(B), will be 0, which turns on transistor A and turns off transistor B. At this point, if the bit stored to the bit storage unit is 1, the non-inverted output from the bit storage unit, Q, will be stored to the output capacitor 206. Otherwise, if the bit stored to the bit storage unit is 0, the inverted output Q(B) will turn on transistor C, thereby connecting the output capacitor 206 to ground.

If the input value is 0, the inverted input, MAC-WL(B), will be 1, which turns off transistor A and turns on transistor B, in which case the output capacitor 206 will be coupled to ground regardless of the value of the bit stored to the bit storage unit 202. To summarize, if the input bit and the weight bit are both 1, then the output capacitor 206 will store a charge representing 1. Otherwise, if either the input bit or the weight bit equal 0, the output capacitor 206 will be discharged.

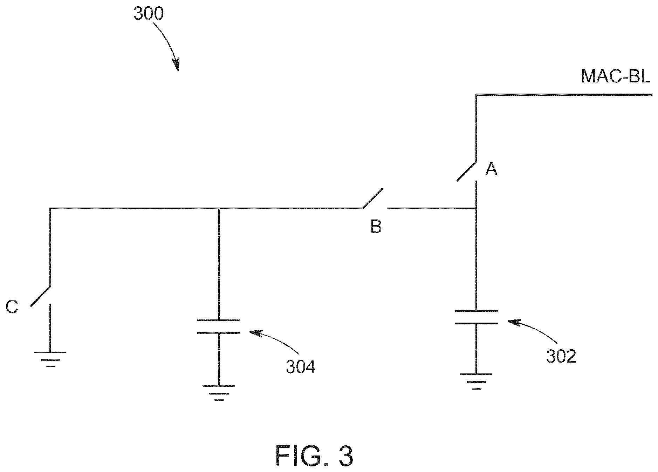

As mentioned above, each bitcell 104 includes an output capacitor 206 to store the multiplication result. Each output capacitor 206 includes a driven plate connected to the output of the multiplication unit 204 and a common plate which is effectively shared between the output capacitors 206 in the same column due to being coupled to one another through the MAC bit line, MAC-BL. The driven plate will be either set to the supply voltage or ground depending on the multiplication result of the individual bitcell 104, while the common plate (MAC-BL) is allowed to settle to an intermediate voltage representing the sum of the multiplication results for all of the bitcells 104 in the column. The relationship between the voltage at the common plate and the ratio of high and low capacitors will be a linear function. Thus, the voltage at the common plate indicates the ratio of high to low output capacitors and, by extension, the summation of all of the multiplication results. Accordingly, the binary digital multiplication result produced by the bitcells 104 in a single column results in an analog voltage at the MAC bit line, MAC-BL, that represents the sum of all the multiplication results provided by the bitcells 104 in the column. The voltage at the MAC bit line, MAC-BL, is stored to a holding capacitor as described in relation to Figs. 3-5.

The charge coupling technique described herein improves the speed, energy efficiency, and accuracy compared to charge sharing techniques for various reasons. In charge sharing, the charge stored to a capacitor is transferred to another capacitor. In charge coupling, a series of parallel capacitors share a common capacitive plate such that the combined charges from all of the capacitors in the series effect the voltage on the common plate. The charge coupling technique described above is an improvement over charge sharing techniques for various reasons. For example, the capacitive coupling mechanism described above is driven by the supply voltage, whereas the charge sharing technique is passive. Accordingly, the steady state voltage can be reached much faster with capacitive coupling compared to charge sharing. Additionally, charge sharing techniques use switching to transfer charges from one capacitor to another, which causes higher energy use as well as introducing charge injection error. Furthermore, in capacitive coupling, the output capacitor is not fully charged or depleted to represent the multiplication result. Rather, the driven plate is set to the supply or ground voltage while the common plate is allowed to settle to an intermediate voltage. Accordingly, the energy to charge or discharge the column of output capacitors 206 is lower than that of a charge sharing circuit.

Fig. 3 is a circuit diagram of a sample-and-hold circuit that is used to store the partial MAC result described in relation to Fig. 2. The partial MAC result is the voltage on the MAC bit line, MAC-BL, after all of the bitcells in the column have performed the multiplication and the output capacitor has settled to a steady state. The partial MAC result is referred to as partial because it represents the summation of the multiplication results for all of the bitcells in a single column (i.e., single weight bit position) and a single input cycle (i.e., single input bit position). As described above, the multiplication of the inputs and the weights is conducted for each input bit individually. Accordingly, the partial MAC results are stored for each input cycle and added to the partial MAC results for each of the previous input cycles until the last bit of the input value has been processed.

The sample-and-hold circuit 300 includes a sampling capacitor 302 and the holding capacitor 304, as well as a number of switches labeled A, B, and C. The sample-and-hold circuit 300 operates in such way that the partial MAC results at each input cycle have an effect on the final charge stored at the holding capacitor 304 commensurate with the corresponding input bit position. This is accomplished by processing the input values in order from the least significant bit to the most significant bit and, at each input cycle, halving the charge stored to the holding capacitor 304 in previous cycles.

Prior to the first input cycle, the holding capacitor 304 is reset by closing switch C while switch B is held open. To sample the partial MAC results, the switch A is closed while switches B and C are open, allowing the sampling capacitor 302 to be charged by the voltage at the MAC bit line, MAC-BL. Next, switch A is opened and switch B is closed, which causes the charges on the sampling capacitor 302 and the holding capacitor 304 to be shared equally. At the end of the first input cycle representing the least significant bit, the holding capacitor 304 will hold a charge equal to half the charge originally stored to the sampling capacitor 302 during the cycle.

Next, the sampling capacitor 302 and the MAC bit line, MAC-BL, are reset using the reset switch, RST_M, (Fig. 2) in preparation for the next input cycle. Once multiplication results have been obtained for the next input cycle, the process repeats. Specifically, the switch A is closed while switches B and C are open, allowing the sampling capacitor 302 to be charged by the voltage at the MAC bit line, MAC-BL. Next, switch A is opened and switch B is closed, which causes the charges on the sampling capacitor 302 and the holding capacitor 304 to be shared equally. At this point half of the charge from the sampling capacitor 302 is effectively shared with the holding capacitor 304, and half of the charge from the holding capacitor 304 is effectively shared with the sampling capacitor 302. Accordingly, the charge stored to the holding capacitor 304 during the first input cycle will be halved again during the second input cycle, while the charge representing the second least significant bit has only been halved once. Repeating the same process for each input cycle causes each successive bit of input to have double the effect on the charge stored to the holding capacitor 304. In an 8-bit system for example, the least significant bit will have been halved 8 times, the second least significant bit will have been halved 7 times, and so on, while the most significant bit will have been halved only once. At the end of the last input cycle, each input cycle's contribution to the final charge stored to the holding capacitor will be proportional to the input cycle's bit significance. In this way, input bit significance is accounted for in the time domain, i.e, depending on the order by which the input bits are processed.

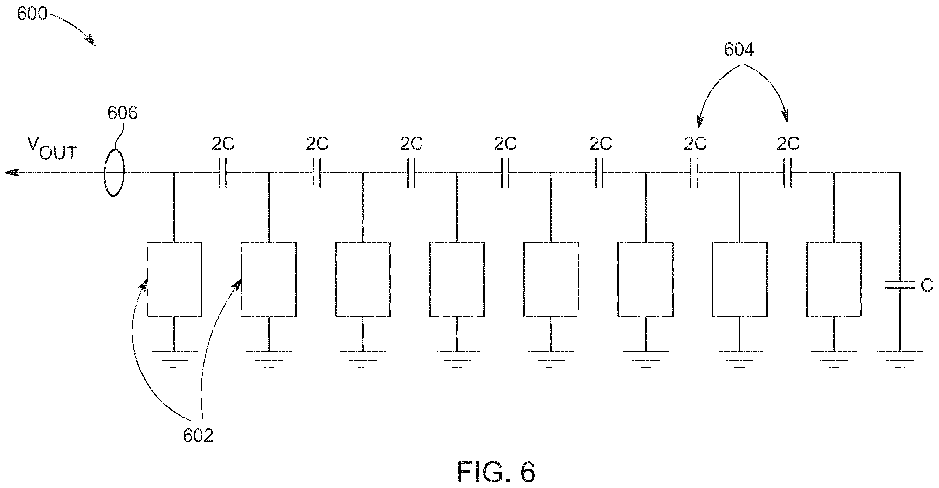

At the end of the eight cycles, the charge on the holding capacitor 304 is an analog value that represents the sum of the multiplication results for an entire column of weight bits for all eight input cycles. As described further in relation to Fig. 6, the holding capacitor 304 will be one holding capacitor in a C-2C ladder. Each column of bitcells 104 will have its own holding capacitor 304 that stores the results for that corresponding column and forms part of the C-2C ladder.

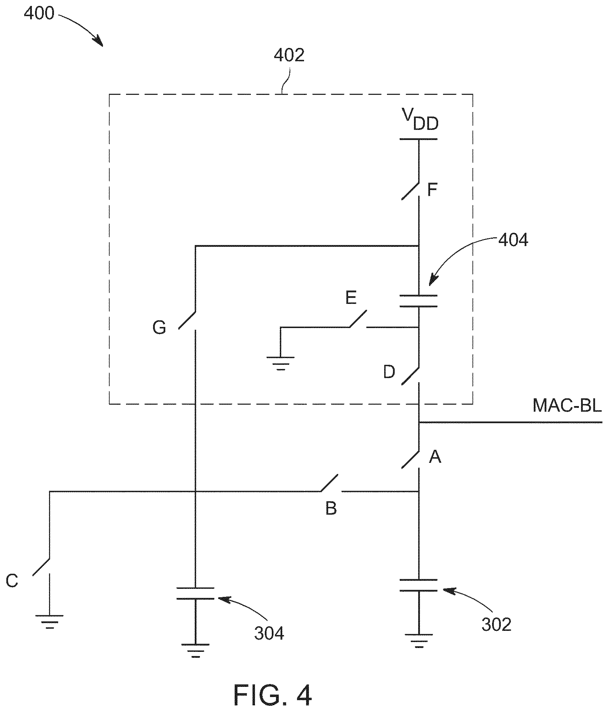

In some embodiments, the system may use 2's compliment arithmetic. In such embodiments, the most significant bit of the input value will be inverted as described in relation to Fig. 4.

Fig. 4 is a circuit diagram of a sample-and-hold circuit that is used to store MAC results in systems that use 2's complement arithmetic. The sample-and-hold circuit 400 includes the sampling capacitor 302, the holding capacitor 304, and switches A, B, and C, as described in Fig. 3. However, the sample-and-hold circuit 400 of Fig. 4 also includes an inverter 402 used to invert the partial MAC result generated for the most significant bit during the last input cycle. The inverter 402 includes a second sampling capacitor 404 and additional switches labeled D, E, F, and G. The second sampling capacitor 404 is coupled to a biased voltage inversion circuit and is used to invert with constant bias the multiplication results received from the output capacitors during a last input cycle corresponding to a most significant bit of the input value.

As the process described in Fig. 3, the holding capacitor 304 is reset prior to the first input cycle using switch C. In this example, the holding capacitor 304 is reset by closing switch C while switches B are G are is held open.

For all but the last input cycle, switches A and B operate in the same manner as described in relation to Fig. 3, while switch D remains open. For the last input cycle, switches A and B remain open while the inverter 402 is used to sample and invert the partial MAC result, MAC-BL, before storing it to the holding capacitor 304. To sample the MAC result for the last input cycle, switches G and E are held closed while switches F and D remain open, which allows the second sampling capacitor 404 to be charged by the voltage at the MAC bit line, MAC-BL. Next, switches G and E are switched opened and then switch F and D is closed. The voltage of across the capacitor 404 remains constant but shifts with respect to the rest of the circuit, i.e. the bottom plate voltage shifts from VMAC-BL to VSS (ground reference), and the top plate voltage shifts the same amount from VDD to VDD-VMAC-BL, thus inverting the voltage with a known constant bias voltage, VDD, to keep the voltage positive.

As mentioned above in relation to Fig. 3, the charge on the holding capacitor 304 at the end of the eight input cycles is an analog value that represents the sum of the multiplication results for an entire column of weight bits and all eight input cycles.

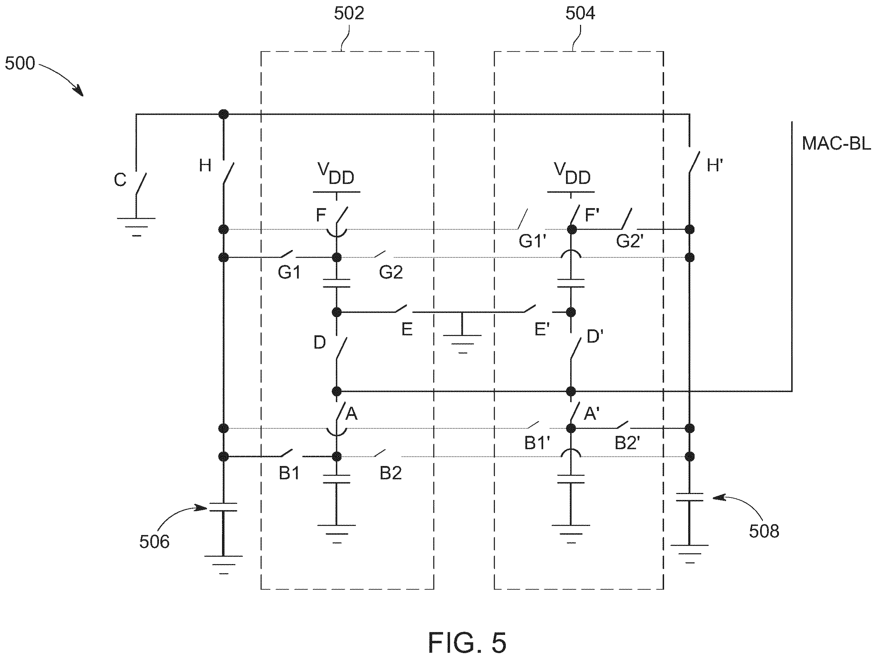

Fig. 5 is a circuit diagram of a sample-and-hold circuit that uses ping-pong buffering and is used to store MAC results in systems that use 2's complement arithmetic. The sample-and-hold circuit 500 of Fig. 5 includes a first sampling circuit 502, a second sampling circuit 504, a first holding capacitor 506, and a second holding capacitor 508.

Both sampling circuits 502 and 504 operate in the same manner as the sample-and-hold circuit 400 described in relation to Fig. 4. Switch lettering is the same for each sample-and-hold circuit, with the exception that the switches of the second sampling circuit 504 are designated with the prime symbol, i.e., switch A is equivalent to switch A', switch B is equivalent to switch B', etc.

As mentioned above, each input value is multiplied by the weights one input bit at a time. The processing of a single input bit takes place during a single input cycle. So for an 8-bit system, the full input value is processed in 8 input cycles.

The effect of using two sampling circuits is that after the first sampling circuit 502 has sampled the MAC results for one bit of a particular input value (e.g., after 1 cycle), the second sampling circuit 504 can be operated to sample new MAC results for the next bit of the input value while the MAC results sampled to the first sampling circuit 502 are coupled to a holding capacitor. Thus, accumulation of the MAC result ping pongs between the two sampling circuits 502 504 for alternating input bits.

The effect of using two holding capacitors is that after completing the sample-and-hold operation of storing the MAC results for a particular input value (e.g., after 8 cycle), the second holding capacitor 508 can be operated to hold the new MAC results of the second input value, while the first holding capacitor 506 is coupled to ADC circuits for further processing.

For the first input value's odd cycles, the charge on the MAC bit line, MAC-BL, is coupled to the first sampling circuit 502 through switch A in case of non-most-significant-bit or switches D, E, and F for most-significant bit (not applicable if input bit precision is even) as described in relation to the sample-and-hold circuit 400 of Fig. 4, while switches A' and D', E', and F' remain open, and the sampling circuit 504 is coupled to holding capacitor 506.

For the first input value's even cycles, the charge on the MAC bit line, MAC-BL, is coupled to the second sampling circuit 504 through switches A' in case of non-most-significant-bit or D', E', and F' for most-significant bit (not applicable if input bit precision is odd) as described in relation to the sample-and-hold circuit 400 of Fig. 4, while switches A and D, E, and F remain open, and the sampling circuit 502 is coupled to holding capacitor 506.

For the first input value, the sampling circuits 502 and 504 are operated in alternate cycles, while the first holding capacitor 506 operates as described in relation to the sample-and-hold circuit 400 of Fig. 4 until all of the bits of the input value have been processed and the first partial MAC result has been accumulated to the first holding capacitor 506. This ping-pong process between the two sampling circuits 502 504, enables sampling of the MAC-BL voltage and charge sharing with the first holding capacitor 506 to proceed in parallel, thereby increasing speed at which the input can be processed.

For the second input value's odd cycles, the charge on the MAC bit line, MAC-BL, is coupled to the first sampling circuit 502 through switch A in case of non-most-significant-bit or switches D, E, and F for most-significant bit (not applicable if input bit precision is even) as described in relation to the sample-and-hold circuit 400 of Fig. 4, while switches A' and D', E', and F' remain open, and the sampling circuit 504 is coupled to the second holding capacitor 508.

For the second input value's even cycles, the charge on the MAC bit line, MAC-BL, is coupled to the second sampling circuit 504 through switch A' in case of non-most-significant-bit or switches D', E', and F' for most-significant bit (not applicable if input bit precision is odd) as described in relation to the sample-and-hold circuit 400 of Fig. 4, while switches A and D, E, and F remain open, and the sampling circuit 502 is coupled to the second holding capacitor 508.

For the second input value, the sampling circuits 502 and 504 are operated in alternate cycles, while the second holding capacitor 508 operates as described in relation to the sample-and-hold circuit 400 of Fig. 4 until all of the input bits of the input value have been processed and the second partial MAC result has been accumulated to the second holding capacitor 508. This ping-pong process between the two sampling circuits 502 504, enables sampling MAC-BL voltage and charge sharing with the second holding capacitor 508 to proceed in parallel, thereby increasing speed at which the input can be processed.

While the second input's MAC result is being accumulated to the second holding capacitor 508 by the sampling circuits of 502 504, the first MAC result stored to the first holding capacitor 506 can simultaneously undergo further processing. After the sampling circuits 502 504 have finished accumulating the MAC result for the second input value to the second holding capacitor 508, the sampling circuits 502 504 can be operated to accumulate the third MAC result to the first holding capacitor 506 while the second holding capacitor 508 undergoes further processing. This ping-pong process between the two holding capacitors 506 508 continues until the full input window has been processed. Ping-ponging between the two holding capacitors 506 508, enables charge accumulation and analog to digital conversion of the MAC results to proceed in parallel, thereby increasing the speed at which the input window can be processed.

Fig. 6 is a circuit diagram of an analog MAC result circuit used to accumulate the partial MAC results generated by the bitcell array in accordance with embodiments. In the described embodiment, the MAC result circuit 600 is a C-2C ladder. However, it will be appreciated that other circuits may be used to accumulate the MAC results. The MAC result circuit 600 of Fig. 6 includes rungs of parallel sample-and-hold circuits 602 separated by capacitors 604 to form a series of voltage divider circuits. Each sample-and-hold circuit 602 may be one of the sample-and-hold circuits 300, 400, or 500 shown in Figs. 3, 4, and 5.

During the processing of the input bits, charge is accumulated to the holding capacitor included in each of the sample-and-hold circuits 602. Once all of the inputs have been processed and it is time to convert the analog MAC result to digital, the sample-and-hold circuit 602 is operated so that the holding capacitor is coupled into the C-2C ladder. In other words, each sample-and-hold circuit 602 will be appear electrically to simply be the holding capacitor 304 (or 506 or 508).

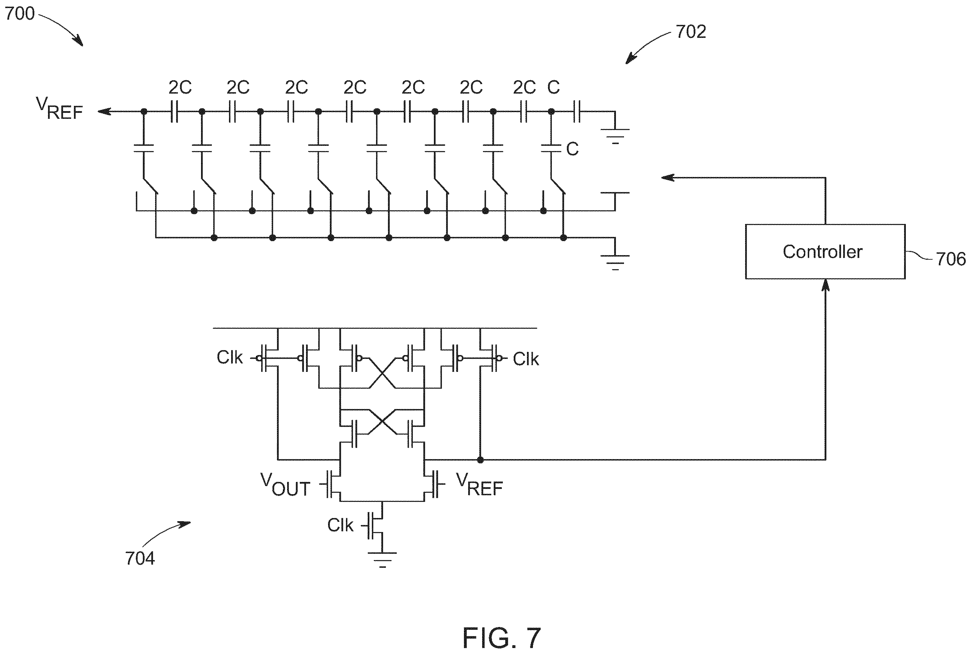

Each sample-and-hold circuit 602 correlates with one of the columns from the bitcell array 102. After the 8 input cycles described above, each sample-and-hold circuit 602 will hold a charge on its holding capacitor 304, 506, or 508 that represents the partial MAC results for a single column of bitcells, i.e., a single weight bit position. Together the sample-and-hold circuits 602 represent the full MAC results, Vₒᵤₜ, for the entire 8-bit weight, which can be measured at the output port 606. The MAC result, Vₒᵤₜ, is an analog voltage that can be sent to the converter 114, which converts the analog value to a digital value. The converter 114 may the converter described in relation to Fig. 7.

As mentioned above, bit significance of the weights is determined by the bit position. In this circuit, the leftmost sample-and-hold circuit 602 represents the most significant bit and the rightmost sample-and-hold circuit 602 represents the least significant bit. The arrangement of the sample-and-hold circuits 602 with the additional capacitors creates a voltage divider circuit so that the effect of each successive sample-and-hold circuit 602, as measured at the output port 606, is reduced by half moving from the most significant bit to the least significant bit. In this way, the bit significance can be represented using equally sized holding capacitors, rather than capacitors that increase exponentially in size. This enables bit-significance presentation at linear cost, with better matching characteristics and higher precision.

Fig. 7 is a circuit diagram of an example converter for converting the MAC results from analog to digital. The converter 700 may be a successive approximation register (SAR) analog to digital converter (ADC), which includes a digital to analog converter (DAC) 702, a comparator 704, and a controller 706. The DAC 702 may be a C-2C ladder, which may be used to generate an analog voltage whose value is determined based on the positions of a set of switches. The controller 706 controls the switches of the C-2C ladder to generate an analog voltage, V_{REF}.

The comparator 704 can include two inverter circuits arranged back-to-back. The reference voltage, V_{REF}, from the DAC 702 is coupled to one side of the inverter circuits through a first switch while the output voltage, V_{OUT}, from the C-2C ladder of Fig. 6 is coupled to the opposite side of the inverter circuits through a second switch. According to this configuration, the comparator 704 can be in one two states, which is determined based on which voltage is higher, V_{REF} or V_{OUT}.

The controller 706 controls the switches of the DAC 702 to arrive at a set of switch positions that generate an analog voltage approximating the output voltage, V_{OUT}. The switch positions are determined in a series of steps progressing from the most significant bit (the leftmost switch) to the least significant bit (the rightmost switch). At each step, the comparator 704 compares the reference voltage with output voltage from the C-2C ladder of Fig. 6 to determine which voltage is higher and adjusts the corresponding switch accordingly.

At the end of the process, the positions of the DAC switches represent the digital value corresponding to the analog output voltage from the C-2C ladder. This digital value represents the results of the multiply accumulate operation for a single input value. The digital value may be stored by the controller 706 to memory or sent to another computing element for further processing.

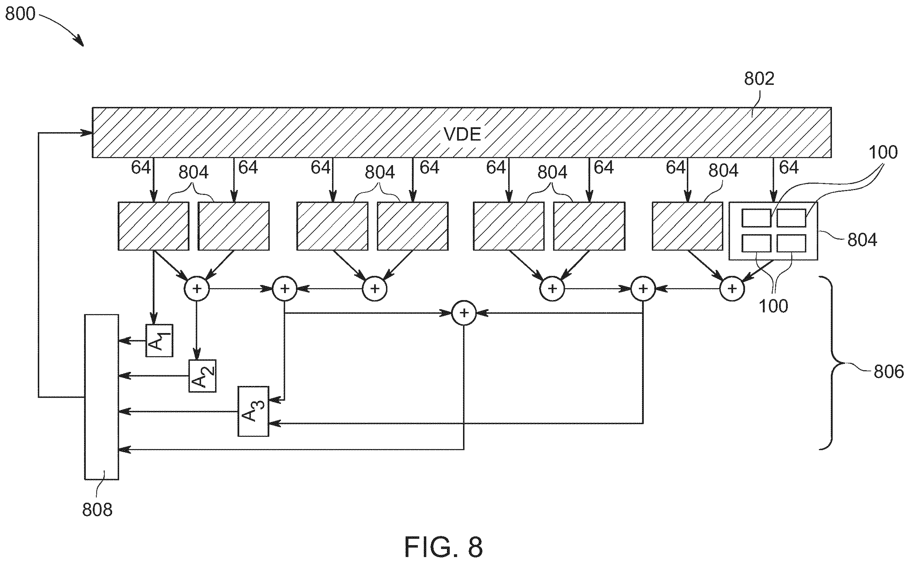

Fig. 8 is a block diagram of a compute-in-memory (CIM) device with multiple compute-in-memory modules as described above in accordance with embodiments. The CIM device shown in Fig. 8 demonstrates the ability to combine multiple CIM modules 100 to handle a wide variety of system configurations. The CIM device 800 of Fig. 8 is configured to process an input window measuring 512 input values across, and each CIM module is configured to handle 64 input values. Therefore, 8 CIM modules are used to cover the entire 512 bit input window. Input is received from a vector data editor (VDE) which handles data arbitration to and from the CIM macros.

Additionally, the system is also configured to process the input using a total of 64 filters, while each CIM module 100 in this example can only hold a total of 16 filters. To extend the capability of the system from 16 filters to 64 filters, the CIM modules 100 are grouped in modules sets 804, each of which includes 4 separate CIM modules 100 that share the 64 bits of input from the VDE.

The MAC results from each set of CIM modules 100 may be added together using an arithmetic unit array (AUA) 806. The arithmetic unit array 806 is an adder tree that can be controlled to sum the MAC results in a variety of ways, depending on the system design and the desired results. In some configurations, the MAC results from each CIM module set 804 is received individually through the A1 multiplexer. For the sake of clarity, only one signal line to the A1 multiplexer is shown. However, it will be appreciated that additional signal lines will connect each of the CIM module sets 804 to the A1 multiplexer. The A1 multiplexer can report the results from each CIM module set 804 to the VDE 802 individually in serial fashion.

In some configurations, the MAC results from pairs of CIM module sets 804 added together at a summing node before being reported to the VDE 802 through the A2 multiplexer. Again, although one signal line is shown to the A2 multiplexer, there will be a signal line from each summing node corresponding with the pairs of CIM module sets. The A2 multiplexer can report the summed results from each pair of CIM module sets 804 to the VDE serially in 4 steps.

In similar fashion, the A3 multiplexer can be selected to report the summed results from half of the CIM module sets 804 to the VDE 802 in two steps. Additionally, all of the CIM module sets 804 may be added together and reported to the VDE 802 in one step. The master multiplexer 808 can be used to determine which reporting configuration will be applied.

It will be appreciated that the specific details described in Fig. 8 are only example implementation details**,** various changes may be made to the number of CIM module sets 804, the number of CIM modules 100 per CIM module set 804, the number of inputs per CIM module 100, and others without departing from the scope as defined by the appended claims.

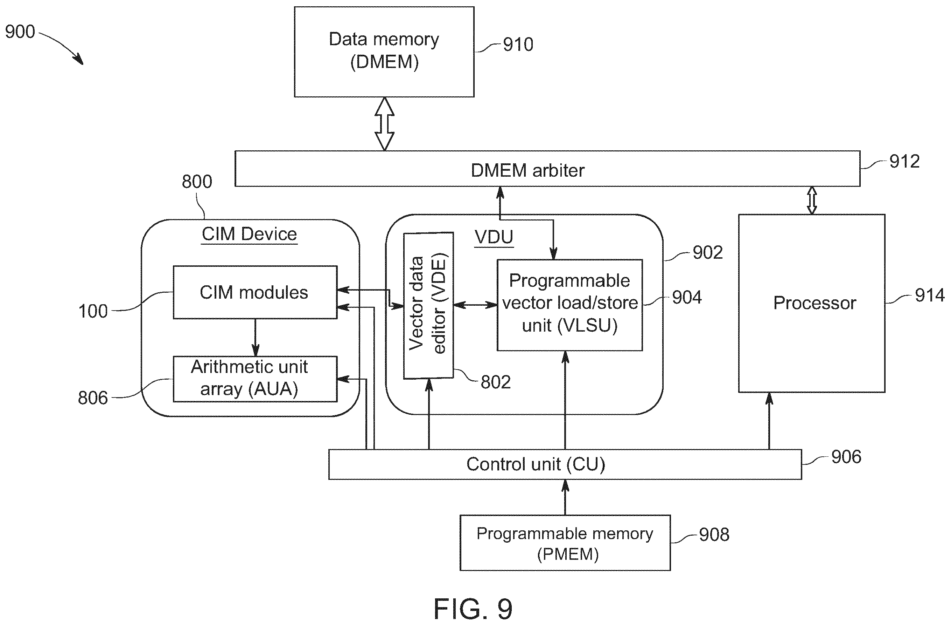

Fig. 9 is a block diagram of an example CIM system in accordance with embodiments. The CIM system 900 includes the CIM device 800 shown in Fig. 8, which includes the CIM modules 100 and the arithmetic unit array 806. The CIM device 800 receives input data from a vector data unit (VDU) 902, which includes the vector data editor 802 shown in Fig. 8. The vector data unit 902 also includes a programmable vector load/store unit (VLSU) 904 coupled to the vector data editor 802. The VLSU 904 controls read and write operations and buffer the inputs or results.

The CIM system 900 also includes a control unit (CU) 906 that controls the operation of the CIM device 800 in accordance with program instructions stored to a program memory (PMEM) 908. For example, the control unit 906 can generate control signals that configure the CIM modules 100 by setting the weight values of the bitcells included in the bitcell arrays. The control unit 906 can also generate signals for configuring the arithmetic unit array 806 to determine how the MAC results are summed and reported. The control unit 906 may be any suitable type of logic unit, such as a microcontroller, an Application Specific Integrated Circuit (ASIC), a Field Programmable Gate Array (FPGA), or an arrangement of logic gates implemented in one or more integrated circuits, for example.

Input data and filter weight data may be stored to a data memory (DMEM) 910 and communicated to the CIM device 800 through the vector data editor 802. The data memory 910 may be any volatile or non-volatile data storage device, such as a hard drive, solid state drive, and others. Memory access to the data memory 910 may be controlled by a data bus or arbiter 912.

The CIM system 900 can also include a general purpose processor 914, which may be any suitable type of central processing unit (CPU) or reduced instruction set computer (RISC). The processor 914 can be used to provide communication between the CIM system 900 and other computing units or peripheral devices. For example, the processor 914 may be coupled to a network that allows the CIM system 900 to communicate with additional remote computing systems and devices. The processor 914 may also be used to specify the parameters of the CIM operations, such as providing the input data and filter weight data to be processed. The processor 914 can also be used to initiate mathematical operations on the data and receive results.

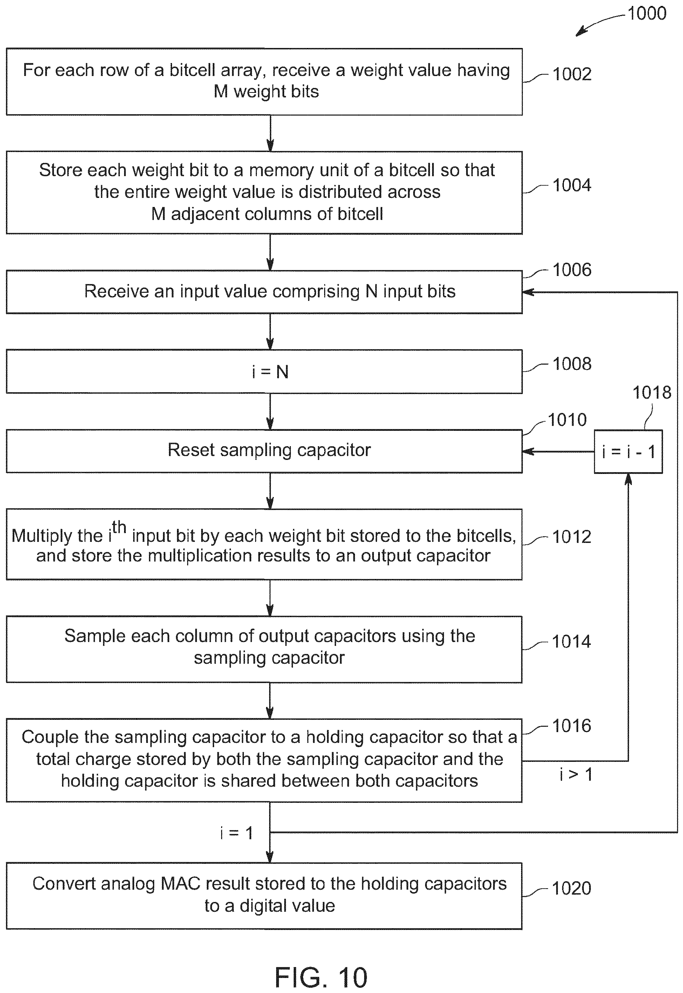

Fig. 10 is a process flow diagram summarizing an example method for performing a multiply accumulate (MAC) operation using an in-memory computing device in accordance with embodiments. The method 1000 is performed using a CIM module as described in any of the examples above. The CIM module may be controlled by a general purpose computer comprising one or more processors and digital memory. The CIM module may also be a part of a computing system, such as the computing system 900 shown in Fig. 9. The method may begin at block 1002.

At block 1002, weight values are received. The weight values are multibit values having M bits each, wherein M may equal 2, 4, 8, 16, or any other suitable value including values in between. A weight value is received for each row of a bitcell array. The weights may be weights that are included in one or more filters, for example.

At block 1004, the weight values are used to populate a bitcell array by storing each weight bit to a memory unit of a bitcell so that the entire weight value is distributed across M adjacent columns of bitcells. The weights are positioned in the bitcell array so that the weight values of a same filter are arranged in columns, with each row being a different weight value. In embodiments in which the bitcell array can handle more than one filter, the additional filter weights may be positioned in adjacent columns.

At block 1006, input values are received. The input values may be values received from an input window, which may be a data file such as an image file, for example. The input values may be received for example by an input buffer of the bitcell array. The input values are multibit values having N bits each, wherein N may equal 2, 4, 8, 16, or any other suitable value including values in between. In some embodiments, the weight values and the input values have the same number of bits (M=N). However, the input and the weights may also have different numbers of bits.

At block 1008, a counter, i, may be set. As described above, the N input bits of each input value are fed into the bitcell array serially, i.e., one bit at a time from the least significant bit to the most significant bit. Accordingly, N input cycles will be used to generate the MAC results for each input value. As used herein, the N^{th} bit refers to the least significant bit and is the first bit to be processed, and bit 1 is the most significant bit, which is the last bit to be processed.

At block 1010, the sampling capacitor is reset. As described above, partial MAC results for each input bit are sampled by a sample-and-hold circuit. Prior to each sampling of the MAC bitline, MAC-BL, the sampling capacitor is reset, i.e., discharged. It will be appreciated that the sample-and-hold circuit includes more than one sampling capacitor.

At block 1012, each of the M weight bits of the weight value is multiplied by the i^{th} input bit. The result for each bitcell is stored to an output capacitor. The same multiplication process may occur in parallel for each bitcell of the bitcell array.

At block 1014, the column of output capacitors is sampled using the sampling capacitor. As described above, each output capacitor in a column shares a common capacitor plate which is conductively coupled via the MAC bitline, MAC-BL. Accordingly, the voltage on the MAC bitline is linearly proportional to the ratio of charged and discharged output capacitors, i.e., the ratio of 1s to 0s.

At block 1016, the sampling capacitor is coupled to a holding capacitor that accumulates the results for each weight bit column across multiple input cycles. Coupling the sampling capacitor to the holding capacitor causes the total charge total charge stored by both the sampling capacitor and the holding capacitor is shared between both capacitors. In other words, half of the charge on the sampling capacitor is shared with the holding capacitor and half of the charge in the holding capacitor is shared with the sampling capacitor. Accordingly, for each input cycle, the holding capacitor's charge due to previous input cycles is cut in half, which accounts for the input bit significance.

If i is greater than one, then the process flow advances from block 1016 to block 1018, and blocks 1010 through 1016 are repeated for the next input bit (i = i - 1). If i equals one, then the N^{th} bit has been processed and the holding capacitors have accumulated the partial MAC results for each of the input bits. At this point, the analog MAC result representing the summed products of the input values and the weight values for each row of the bitcell array have been stored to the holding capacitors. The process flow may then advance to block 1020.

At block 1020, the analog MAC result stored to the holding capacitors is converted to a digital value. At the same time that the analog to digital conversion is taking place, an additional process flow may also branch off and return to block 1006. At block 1006, a new input value is received and the MAC process repeats for the new input value using different sample-and-hold circuits.

Blocks 1006 through 1020 may be repeated for each input value until an entire input window is processed. The results may be stored to memory as an output feature map and may be subject to further processing depending on the design details of a specific implementation

It will be appreciated that the process described herein is a simplified version of the techniques described above**.** The method 1300 may be repeated for multiple channels of input and/or multiple filters. Additionally, it will be appreciated that the processes described are performed by machinery, including in-memory computing circuits, digital circuits, or a combination thereof.

It is to be understood that what is described above is what is presently considered the preferred embodiments. However, it should be noted that various modifications may be made without departing from the scope as defined by the appended claims.

## Claims

1. An apparatus for performing a convolution comprising:
a bitcell array (100) to perform a multiply-accumulate (MAC) operation using a multibit weight and a multibit input, wherein the bitcell array comprises a plurality of bitcells (104), and wherein each bitcell of the bitcell array comprises a corresponding memory unit (202) to store a corresponding weight bit of the multibit weight, a corresponding multiplication unit (204) to multiply the corresponding weight bit by an input bit of the multibit input, and a corresponding output capacitor (206) to store a result of the multiplication;
sample-and-hold circuits (300, 400, 500) coupled to the output capacitors of corresponding columns of bitcells, each sample-and-hold circuit comprising a corresponding holding capacitor (304, 506, 508) to store a charge representing a partial MAC result for the corresponding column;
an input buffer (108) to serially send input bits of the multibit input to the bitcell array to be multiplied by the multibit weights in a series of input cycles, wherein each sample-and-hold circuit is configured to, in each input cycle of said series of input cycles:
sample a voltage on a corresponding column line coupled to the corresponding output capacitors in order to provide a sampled charge;
if the input cycle is after the first occurring input cycle of the series, reduce the charge stored at the end of the previous cycle in the corresponding holding capacitor by half;
add half of the sampled charge to the charge of the corresponding holding capacitor; and
an analog MAC result circuit (600) comprising the holding capacitors, each holding capacitor associated to a corresponding weight bit significance, the analog MAC result circuit configured to generate, from the charges stored in the holding capacitors at the end of the series of input cycles, an analog MAC result being a summed product of the multibit input and the multibit weight.

2. The apparatus of claim 1, wherein each output capacitor of a column of bitcells is coupled to its corresponding sample-and-hold circuit through capacitive coupling with a common capacitor plate.

3. The apparatus of any one of claims 1 to 2, wherein each sample-and-hold circuit comprises a corresponding sampling capacitor (302, 404), and wherein reducing the charge stored to the holding capacitor by half at each input cycle comprises:
charging the sampling capacitor by coupling the sampling capacitor to the output capacitors for the corresponding column of bitcells; and
coupling the sampling capacitor to the holding capacitor so that a total charge stored by both the sampling capacitor and the holding capacitor is shared between both capacitors.

4. The apparatus of any one of claims 1 to 3, wherein the holding capacitor is a corresponding first holding capacitor (506) and each sample-and-hold circuit comprises a corresponding second holding capacitor (508), wherein during processing for a first multibit input, the partial MAC result is stored to the first holding capacitor, and during processing for a second multibit input, the partial MAC result is stored to the second holding capacitor while the partial MAC result stored to the first holding capacitor is used to convert the MAC result to a digital value.

5. The apparatus of any one of claims 1 to 4, wherein each sample-and-hold circuit comprises a corresponding first sampling circuit (502) and a corresponding second sampling circuit (504), wherein accumulation of the partial MAC results ping pongs between the first sampling circuit and the second sampling circuit for alternating input bits.

6. The apparatus of any one of claims 1 to 5, wherein the sample-and-hold circuit comprises:
a corresponding first sampling capacitor (302); and
a corresponding second sampling capacitor (404) coupled to a biased voltage inversion circuit (402);
wherein the second sampling capacitor is used to invert with constant bias the multiplication results received from the output capacitors during a last input cycle corresponding to a most significant bit of the multibit input.

7. The apparatus of any one of claims 1 to 6, wherein the analog MAC result circuit comprises a C-2C ladder comprising the holding capacitors coupled in parallel through additional capacitors (604) to form a voltage divider circuit.

8. The apparatus of any one of claims 1 to 7, wherein the holding capacitors used to store the MAC results are a same size for each column.

9. The apparatus of any one of claims 1 to 8, wherein the multibit weight is an 8-bit value occupying 8 columns of the bitcell array, the multibit input is an 8-bit value, and the series of input cycles to generate the MAC result comprises 8 input cycles.

10. The apparatus of any one of claims 1 to 9, wherein the bitcell array comprises a first set of columns representing a first filter and a second set of columns representing a second filter.

11. A method comprising:
for each row of a bitcell array (100), receiving (1002) a weight value comprising M weight bits and receiving an input value comprising N input bits;
for each weight bit, storing (1004) the weight bit to a memory unit (202) of a bitcell (104), wherein an entire weight value is distributed across M adjacent columns of bitcells; and
computing an analog MAC result representing summed products of the input values and the weight values for rows of the bitcell array, wherein computing the analog MAC result comprises:
for each of N input cycles:
for each row sending a corresponding input bit of the input value to the bitcell array;
for each row multiplying (1012) the corresponding input bit of the input value by each weight bit stored to the bitcells;
for each row storing (1012) a result of the multiplying to a corresponding output capacitor (206) of each bitcell;
for each sampling capacitor (302, 404) of a sample-and-hold circuit (300, 400, 500), charging the sampling capacitor by coupling, for a sampling period, the sampling capacitor to the output capacitors of a corresponding column of bit cells;
for each sampling capacitor, after the sampling period, coupling (1016) the charged sampling capacitor to a corresponding holding capacitor (304, 506, 508) so that a total charge stored by both the sampling capacitor and the corresponding holding capacitor is shared between both capacitors; and
decoupling each sampling capacitor from the corresponding holding capacitor.

12. The method of claim 11, comprising, for a last of the N input cycles, inverting the charge stored to the sampling capacitor (404) with constant bias before coupling the sampling capacitor to the holding capacitor.

13. The method of any one of claims 11 to 12, wherein the holding capacitors form a C-2C ladder comprising the holding capacitors coupled in parallel through additional capacitors (604) to form a voltage divider circuit, wherein weight bit significance is determined based on positions of the holding capacitors in the C-2C ladder.

14. The method of any one of claim13, comprising, after the N input cycles, converting (1020) the analog MAC result stored in the C-2C ladder to a digital value.

15. The method of any one of claims 11 to 14, comprising, after the N input cycles and while converting the analog MAC result to a digital value:
for each row of the bitcell array, receiving (1006) a next input value comprising N input bits; and
computing a next analog MAC result representing the sum of the product of the next input values and the weight values for each row of the bitcell array, wherein the next analog MAC result is stored to a second set of holding capacitors.

## Patentansprüche

1. Vorrichtung zum Durchführen einer Faltung, die Folgendes umfasst:
ein Bitzellenarray (100) zum Durchführen einer Multiplikationsakkumulations(MAC)-Operation unter Verwendung einer Multibitgewichtung und einer Multibiteingabe, wobei das Bitzellenarray eine Vielzahl von Bitzellen (104) umfasst und wobei jede Bitzelle des Bitzellenarrays eine entsprechende Speichereinheit (202) zum Speichern eines entsprechenden Gewichtungsbits der Multibitgewichtung, eine entsprechende Multiplikationseinheit (204) zum Multiplizieren des entsprechenden Gewichtungsbits mit einem Eingabebit der Multibiteingabe und einen entsprechenden Ausgabekondensator (206) zum Speichern eines Ergebnisses der Multiplikation umfasst;
Abtasten-und-Halten-Schaltungen (300, 400, 500), die an die Ausgabekondensatoren von entsprechenden Spalten von Bitzellen gekoppelt sind, wobei jede Abtasten-und-Halten-Schaltung einen entsprechenden Haltekondensator (304, 506, 508) zum Speichern einer Ladung, die ein teilweises MAC-Ergebnis für die entsprechende Spalte repräsentiert, umfasst;
einen Eingabepuffer (108) zum seriellen Senden von Eingabebits der Multibiteingabe an das Bitzellenarray, die in einer Reihe von Eingabezyklen mit den Multibitgewichtungen zu multiplizieren sind, wobei jede Abtasten-und-Halten-Schaltung bei jedem Eingabezyklus der Reihe von Eingabezyklen zu Folgendem ausgelegt ist:
Abtasten einer Spannung in einer entsprechenden Spaltenleitung, die an die entsprechenden Ausgabekondensatoren gekoppelt ist, um eine abgetastete Ladung bereitzustellen;
Reduzieren der Ladung, die am Ende des vorherigen Zyklus im entsprechenden Haltekondensator gespeichert wird, um die Hälfte, wenn der Eingabezyklus nach dem ersten erfolgenden Eingabezyklus der Reihe erfolgt;
Hinzufügen einer Hälfte der abgetasteten Ladung zur Ladung des entsprechenden Haltekondensators; und
eine analoge MAC-Ergebnisschaltung (600), die die Haltekondensatoren umfasst, wobei jeder Haltekondensator mit einer entsprechenden Gewichtungsbitsignifikanz verknüpft ist, wobei die analoge MAC-Ergebnisschaltung dazu ausgelegt ist, aus den Ladungen, die in den Haltekondensatoren am Ende der Reihe von Eingabezyklen gespeichert werden, ein analoges MAC-Ergebnis zu erzeugen, bei dem es sich um ein summiertes Produkt der Multibiteingabe und der Multibitgewichtung handelt.

2. Vorrichtung nach Anspruch 1, wobei jeder Ausgabekondensator einer Spalte von Bitzellen mittels einer kapazitiven Kopplung mit einer gemeinsamen Kondensatorplatte an seine entsprechende Abtasten-und-Halten-Schaltung gekoppelt ist.

3. Vorrichtung nach einem der Ansprüche 1 bis 2, wobei jede Abtasten-und-Halten-Schaltung einen entsprechenden Abtastkondensator (302, 404) umfasst, und wobei das Reduzieren der Ladung, die im Haltekondensator gespeichert ist, bei jedem Eingabezyklus um die Hälfte Folgendes umfasst:
Laden des Abtastkondensators durch Koppeln des Abtastkondensators an die Ausgabekondensatoren für die entsprechende Spalte von Bitzellen; und
Koppeln des Abtastkondensators an den Haltekondensator, derart, dass eine Gesamtladung, die sowohl vom Abtastkondensator als auch vom Haltekondensator gespeichert wird, von beiden Kondensatoren gemeinsam verwendet wird.

4. Vorrichtung nach einem der Ansprüche 1 bis 3, wobei der Haltekondensator ein entsprechender erster Haltekondensator (506) ist und jede Abtasten-und-Halten-Schaltung einen entsprechenden zweiten Haltekondensator (508) umfasst, wobei während des Verarbeitens für eine erste Multibiteingabe das partielle MAC-Ergebnis im ersten Haltekondensator gespeichert wird und während des Verarbeitens für eine zweite Multibiteingabe das partielle MAC-Ergebnis im zweiten Haltekondensator gespeichert wird, während das partielle MAC-Ergebnis, das im ersten Haltekondensator gespeichert ist, verwendet wird, um das MAC-Ergebnis in einen digitalen Wert umzuwandeln.

5. Vorrichtung nach einem der Ansprüche 1 bis 4, wobei die Abtasten-und-Halten-Schaltung eine entsprechende erste Abtastschaltung (502) und eine entsprechende zweite Abtastschaltung (504) umfasst, wobei eine Akkumulation der partiellen MAC-Ergebnisse zwischen der ersten Abtastschaltung und der zweiten Abtastschaltung zum Alternieren von Eingabebits hin und her wechselt.

6. Vorrichtung nach einem der Ansprüche 1 bis 5, wobei die Abtasten-und-Halten-Schaltung Folgendes umfasst:
einen entsprechenden ersten Abtastkondensator (302); und
einen entsprechenden zweiten Abtastkondensator (404), der an eine Vorspannungsinversionsschaltung (402) gekoppelt ist;
wobei der zweite Abtastkondensator verwendet wird, um die Multiplikationsergebnisse, die während eines letzten Eingabezyklus, der einem höchstwertigen Bit der Multibiteingabe entspricht, von den Ausgabekondensatoren empfangen werden, mit einer konstanten Vorspannung zu invertieren.

7. Vorrichtung nach einem der Ansprüche 1 bis 6, wobei die analoge MAC-Ergebnisschaltung eine C-2C-Leiter umfasst, die die Haltekondensatoren umfasst, die über zusätzliche Kondensatoren (604) parallel gekoppelt sind, um eine Spannungsteilerschaltung zu bilden.

8. Vorrichtung nach einem der Ansprüche 1 bis 7, wobei die Haltekondensatoren, die zum Speichern der MAC-Ergebnisse verwendet werden, für jede Spalte eine selbe Größe aufweisen.

9. Vorrichtung nach einem der Ansprüche 1 bis 8, wobei die Multibitgewichtung ein 8-Bit-Wert ist, der 8 Spalten des Bitzellenarrays belegt, wobei die Multibiteingabe ein 8-Bit-Wert ist und die Reihe von Eingabezyklen zum Erzeugen des MAC-Ergebnisses 8 Eingabezyklen umfasst.

10. Vorrichtung nach einem der Ansprüche 1 bis 9, wobei das Bitzellenarray einen ersten Satz von Spalten, die ein erstes Filter repräsentieren, und einen zweiten Satz von Spalten, die ein zweites Filter repräsentieren, umfasst.

11. Verfahren, das Folgendes umfasst:
für jede Reihe eines Bitzellenarrays (100) Empfangen (1002) eines Gewichtungswertes, der M Gewichtungsbits umfasst, und Empfangen eines Eingabewertes, der N Eingabebits umfasst;
für jedes Gewichtungsbit Speichern (1004) des Gewichtungsbits in einer Speichereinheit (202) einer Bitzelle (104), wobei ein gesamter Gewichtungswert auf M benachbarte Spalten von Bitzellen verteilt ist; und
Berechnen eines analogen MAC-Ergebnisses, das summierte Produkte der Eingabewerte und der Gewichtungswerte repräsentiert, für Reihen des Bitzellenarrays, wobei das Berechnen des analogen MAC-Ergebnisses Folgendes umfasst:
für jeden von N Eingabezyklen:
Senden eines entsprechenden Eingabebits des Eingabewertes für jede Reihe an das Bitzellenarray;
Multiplizieren (1012) des entsprechenden Eingabebits des Eingabewertes für jede Reihe mit dem Gewichtungsbit, das in den Bitzellen gespeichert ist;
Speichern (1012) eines Ergebnisses des Multiplizierens für jede Reihe in einem entsprechenden Ausgabekondensator (206) von jeder Bitzelle;
für jeden Abtastkondensator (302, 404) einer Abtasten-und-Halten-Schaltung (300, 400, 500) Laden des Abtastkondensators durch Koppeln des Abtastkondensators an die Ausgabekondensatoren einer entsprechenden Spalte von Bitzellen für eine Abtastperiode;
für jeden Abtastkondensator nach der Abtastperiode Koppeln (1016) des geladenen Abtastkondensators an einen entsprechenden Haltekondensator (304, 506, 508), derart, dass eine Gesamtladung, die sowohl vom Abtastkondensator als auch vom entsprechenden Haltekondensator gespeichert wird, von den beiden Kondensatoren gemeinsam verwendet wird; und
Entkoppeln von jedem Abtastkondensator vom entsprechenden Haltekondensator.

12. Verfahren nach Anspruch 11, das für einen letzten der N Eingabezyklen das Invertieren der im Abtastkondensator (404) gespeicherten Ladung mit einer konstanten Vorspannung, bevor der Abtastkondensator an den Haltekondensator gekoppelt wird, umfasst.

13. Verfahren nach einem der Ansprüche 11 bis 12, wobei die Haltekondensatoren eine C-2C-Leiter bilden, die die Haltekondensatoren, die über zusätzliche Kondensatoren (604) parallel gekoppelt sind, um eine Spannungsteilerschaltung zu bilden, umfasst, wobei eine Gewichtungsbitsignifikanz auf Basis von Positionen der Haltekondensatoren in der C-2C-Leiter bestimmt wird.

14. Verfahren nach einem von Anspruch 13, das nach den N Eingabezyklen das Umwandeln (1020) des analogen MAC-Ergebnisses, das in der C-2C-Leiter gespeichert ist, in einen digitalen Wert umfasst.

15. Verfahren nach einem der Ansprüche 11 bis 14, das nach den N Eingabezyklen und während des Umwandelns des analogen MAC-Ergebnisses in einen digitalen Wert Folgendes umfasst:
Empfangen (1006) eines nächsten Eingabewertes, der N Eingabebits umfasst, für jede Reihe des Bitzellenarrays; und
Berechnen eines nächsten analogen MAC-Ergebnisses, das die Summe des Produkts der nächsten Eingabewerte und der Gewichtungswerte repräsentiert, für jede Reihe des Bitzellenarrays, wobei das nächste analoge MAC-Ergebnis in einem zweiten Satz von Haltekondensatoren gespeichert wird.

## Revendications

1. Appareil pour effectuer une convolution comprenant :
un réseau de cellules binaires (100) pour effectuer une opération de multiplication-cumul (MAC) en utilisant un poids multibit et une entrée multibit, dans lequel le réseau de cellules binaires comprend une pluralité de cellules binaires (104), et dans lequel chaque cellule binaire du réseau de cellules binaires comprend une unité de mémoire (202) correspondante pour stocker un bit de poids correspondant du poids multibit, une unité de multiplication (204) correspondante pour multiplier le bit de poids correspondant par un bit d'entrée de l'entrée multibit, et un condensateur de sortie (206) correspondant pour stocker un résultat de la multiplication ;
des circuits d'échantillonnage et de maintien (300, 400, 500) couplés aux condensateurs de sortie de colonnes correspondantes des cellules binaires, chaque circuit d'échantillonnage et de maintien comprenant un condensateur de maintien (304, 506, 508) correspondant pour stocker une charge représentant un résultat MAC partiel pour la colonne correspondante ;
un tampon d'entrée (108) pour envoyer en série des bits d'entrée de l'entrée multibit au réseau de cellules binaires afin de les multiplier par les poids multibit dans une série de cycles d'entrée, dans lequel chaque circuit d'échantillonnage et de maintien est configuré pour, dans chaque cycle d'entrée de ladite série de cycles d'entrée :
échantillonner une tension sur une ligne de colonne correspondante couplée aux condensateurs de sortie correspondants afin de fournir une charge échantillonnée ;
si le cycle d'entrée est postérieur au premier cycle d'entrée en cours de la série, réduire de moitié la charge stockée à la fin du cycle précédent dans le condensateur de maintien correspondant ;
ajouter la moitié de la charge échantillonnée à la charge du condensateur de maintien correspondant ; et
un circuit de résultat MAC analogique (600) comprenant les condensateurs de maintien, chaque condensateur de maintien étant associé à une signification de bit de poids correspondant, le circuit de résultat MAC analogique étant configuré pour générer, à partir des charges stockées dans les condensateurs de maintien à la fin de la série de cycles d'entrée, un résultat MAC analogique qui est le produit de la somme de l'entrée multibit et du poids multibit.

2. Appareil selon la revendication 1, dans lequel chaque condensateur de sortie d'une colonne des cellules binaires est couplé à son circuit d'échantillonnage et de maintien correspondant par couplage capacitif avec une plaque de condensateur commune.

3. Appareil selon l'une des revendications 1 et 2, dans lequel chaque circuit d'échantillonnage et de maintien comprend un condensateur d'échantillonnage (302, 404) correspondant, et dans lequel la réduction de moitié de la charge stockée dans le condensateur de maintien à chaque cycle d'entrée comprend :
la charge du condensateur d'échantillonnage en couplant le condensateur d'échantillonnage aux condensateurs de sortie pour la colonne correspondante des cellules binaires; et
la couplage du condensateur d'échantillonnage au condensateur de maintien de sorte qu'une charge totale stockée à la fois par le condensateur d'échantillonnage et le condensateur de maintien soit partagée entre les deux condensateurs.

4. Appareil selon l'une des revendications 1 à 3, dans lequel le condensateur de maintien est un premier condensateur de maintien (506) correspondant, et chaque circuit d'échantillonnage et de maintien comprend un deuxième condensateur de maintien (508) correspondant, dans lequel, pendant le traitement d'une première entrée multibit, le résultat MAC partiel est stocké dans le premier condensateur de maintien, et pendant le traitement d'une deuxième entrée multibit, le résultat MAC partiel est stocké dans le deuxième condensateur de maintien tandis que le résultat MAC partiel stocké dans le premier condensateur de maintien est utilisé pour convertir le résultat MAC en une valeur numérique.

5. Appareil selon l'une des revendications 1 à 4, dans lequel chaque circuit d'échantillonnage et de maintien comprend un premier circuit d'échantillonnage (502) correspondant et un deuxième circuit d'échantillonnage (504) correspondant, dans lequel le cumul des résultats MAC partiels fait des va-et-vient entre le premier circuit d'échantillonnage et le deuxième circuit d'échantillonnage pour alterner les bits d'entrée.

6. Appareil selon l'une des revendications 1 à 5, dans lequel le circuit d'échantillonnage et de maintien comprend :
un premier condensateur d'échantillonnage (302) correspondant ; et
un deuxième condensateur d'échantillonnage (404) correspondant couplé à un circuit d'inversion de tension polarisé (402) ;
dans lequel le deuxième condensateur d'échantillonnage est utilisé pour inverser avec une polarisation constante les résultats de multiplication reçus des condensateurs de sortie pendant un dernier cycle d'entrée correspondant au bit le plus significatif de l'entrée multibit.

7. Appareil selon l'une des revendications 1 à 6, dans lequel le circuit de résultat MAC analogique comprend une échelle C-2C comprenant les condensateurs de maintien couplés en parallèle par l'intermédiaire de condensateurs (604) supplémentaires pour former un circuit diviseur de tension.

8. Appareil selon l'une des revendications 1 à 7, dans lequel les condensateurs de maintien utilisés pour stocker les résultats MAC sont de la même taille pour chaque colonne.

9. Appareil selon l'une des revendications 1 à 8, dans lequel le poids multibit est une valeur à 8 bits occupant 8 colonnes du réseau de cellules binaires, l'entrée multibit est une valeur à 8 bits, et la série de cycles d'entrée pour générer le résultat MAC comprend 8 cycles d'entrée.

10. Appareil selon l'une des revendications 1 à 9, dans lequel le réseau de cellules binaires comprend un premier ensemble de colonnes représentant un premier filtre et un deuxième ensemble de colonnes représentant un deuxième filtre.

11. Procédé comprenant :
pour chaque rangée d'un réseau de cellules binaires (100), la réception (1002) d'une valeur de poids comprenant M bits de poids, et la réception d'une valeur d'entrée comprenant N bits d'entrée ;
pour chaque bit de poids, le stockage (1004) du bit de poids dans une unité de mémoire (202) d'une cellule binaire (104), dans lequel une valeur de poids entière est répartie sur M colonnes adjacentes de cellules binaires ; et
le calcul d'un résultat MAC analogique représentant les produits de la somme des valeurs d'entrée et des valeurs de poids des rangées du réseau de cellules binaires, dans lequel le calcul du résultat MAC analogique comprend :
pour chacun des N cycle d'entrées :
pour chaque rangée, l'envoi d'un bit d'entrée correspondant de la valeur d'entrée au réseau de cellules binaires ;
pour chaque rangée, la multiplication (1012) du bit d'entrée correspondant de la valeur d'entrée par chaque bit de poids stocké dans les cellules binaires ;
pour chaque rangée, le stockage (1012) d'un résultat de la multiplication dans un condensateur de sortie (206) correspondant de chaque cellule binaire ;
pour chaque condensateur d'échantillonnage (302, 404) d'un circuit d'échantillonnage et de maintien (300, 400, 500), la charge du condensateur d'échantillonnage en couplant pendant une période d'échantillonnage le condensateur d'échantillonnage aux condensateurs de sortie d'une colonne correspondante de cellules binaires ;
pour chaque condensateur d'échantillonnage, après la période d'échantillonnage, la couplage (1016) du condensateur d'échantillonnage chargé à un condensateur de maintien correspondant (304, 506, 508), de sorte qu'une charge totale stockée à la fois par le condensateur d'échantillonnage et le condensateur de maintien correspondant soit partagée entre les deux condensateurs ; et
le découplage de chaque condensateur d'échantillonnage du condensateur de maintien correspondant.

12. Procédé selon la revendication 11, comprenant, pour un dernier cycle d'entrée des N cycles d'entrée, l'inversion de la charge stockée dans le condensateur d'échantillonnage (404) avec des polarisations constantes avant de coupler le condensateur d'échantillonnage au condensateur de maintien.

13. Procédé selon l'une des revendications 11 à 12, dans lequel les condensateurs de maintien forment une échelle C-2C comprenant les condensateurs de maintien couplés en parallèle par l'intermédiaire de condensateurs (604) supplémentaires pour former un circuit diviseur de tension, dans lequel signification de bit de poids est déterminée sur la base des positions des condensateurs de maintien dans l'échelle C-2C.

14. Procédé selon l'une des revendications 13, comprenant, après les N cycles d'entrée, la conversion (1020) du résultat MAC analogique stocké dans l'échelle C-2C en une valeur numérique.

15. Procédé selon l'une des revendications 11 à 14, comprenant, après les N cycles d'entrée et lors de la conversion du résultat MAC analogique en une valeur numérique :
pour chaque rangée du réseau de cellules binaires, la réception (1006) d'une prochaine valeur d'entrée comprenant N bits d'entrée ; et
le calcul d'un prochain résultat MAC analogique représentant la somme du produit des prochaines valeurs d'entrée et des valeurs de poids pour chaque rangée du réseau de cellules binaires, dans lequel le prochain résultat MAC analogique est stocké dans un deuxième ensemble de condensateurs de maintien.
